## Europäisches Patentamt
## European Patent Office
## Office européen des brevets

(19)

(11) Numéro de publication: **0 121 461**
**B1**

(12) # FASCICULE DE BREVET EUROPEEN

(45) Date de publication du fascicule du brevet:
**11.03.87**

(51) Int. Cl.⁴: **H 03 M 7/30,** H 03 M 7/22

(21) Numéro de dépôt: **84400502.5**

(22) Date de dépôt: **13.03.84**

(54) Décodeur d'une donnée dans un sous-groupe de P données appartenant à un groupe de N données.

(30) Priorité: **25.03.83 FR 8304977**

(43) Date de publication de la demande:
**10.10.84 Bulletin 84/41**

(45) Mention de la délivrance du brevet:
**11.03.87 Bulletin 87/11**

(84) Etats contractants désignés:
**AT DE FR GB IT**

(56) Documents cités:
**EP - A - 0 065 460**

**IBM TECHNICAL DISCLOSURE BULLETIN, vol. 20, no. 8, janvier 1978, pages 3193-3196, New York, USA; G. KRIEG: "Arrangement for decompressing compressed data"**

(73) Titulaire: **SOCIETE POUR L'ETUDE ET LA FABRICATION DE CIRCUITS INTEGRES SPECIAUX - E.F.C.I.S., 17, avenue des Martyrs, F-38100 Grenoble (FR)**

(72) Inventeur: **Meyer, Jacques, THOMSON-CSF SCPI 173, bld Haussmann, F-75379 Paris cedex 08 (FR)**

(74) Mandataire: **Guérin, Michel et al, THOMSON-CSF SCPI 19, avenue de Messine, F-75008 Paris (FR)**

## Description

La présente invention concerne de façon générale un décodeur permettant de sélectionner une donnée prédéterminée dans un groupe de P données, ces P données faisant partie d'un groupe plus important de N données. La présente invention trouve notamment des applications dans les systèmes d'affichage graphiques et alphanumériques, mais pourra s'appliquer au décodage de données dans de nombreux autres cas.

Dans la description suivante de l'art antérieur et de la présente invention, on considérera généralement le cas où $N = 2^n$ et où $P = 2^p$. Néanmoins, P et N peuvent être quelconques du moment que P est inférieur ou égal à N.

La présente invention s'intéresse aux décodeurs dans le cas particulier où l'on cherche à effectuer un décodage en temps réel, ce qui exclut par exemple l'emploi de compteurs explorant séquentiellement un registre pour déterminer l'emplacement du premier ou du $n^{ième}$ «1» contenu dans ce registre. En informatique, dans de nombreux cas, on cherche à retrouver une donnée faisant partie d'un ensemble de N données. Pour cela, il convient de prévoir une mémoire ou un registre contenant ces N données et un adressage de cette mémoire. Cet adressage doit correspondre à un mot de n bits si $N = 2^n$. Si l'on a enregistré une succession d'événements correspondant à l'incidence successive des diverses données, on enregistrera la succession des mots de n bits correspondant aux adresses des données. Si l'on tient à mémoriser une séquence importante de données, ou plus exactement d'adresses de données, il est souhaitable que ces adresses soient aussi courtes que possible.

Il existe un cas au moins où il est possible de raccourcir la longueur du mot d'adresse à une valeur inférieure à n. C'est le cas où, pendant une séquence déterminée, la donnée choisie n'est pas l'une quelconque des N données, mais appartient à un sous-groupe P de ces N données. On concevra alors que, pendant cette séquence, on puisse désigner la donnée recherchée par son numéro d'ordre ou son adresse parmi les P données, c'est-à-dire utiliser une adresse de seulement p bits si $P = 2^p$. Il reste alors à faire la corrélation entre l'adresse ou le numéro d'ordre parmi les P données et l'adresse ou le numéro d'ordre parmi les N données. En d'autres termes, à partir du numéro parmi les P données, il faut déterminer le numéro parmi les N données.

Pour résoudre ce problème, si l'on utilise les méthodes classiques et immédiates de l'informatique, on considérera qu'il existe $2^N$ combinaisons des N données et qu'il faudra donc prévoir un décodeur comprenant une mémoire morte ou un réseau logique programmable d'une capacité ou d'un nombre de nœuds égal à $p.n.2^N$.

La présente invention vise à réaliser un décodeur particulièrement simple et n'exigeant pas une mémoire de si grande capacité.

Pour atteindre cet objet, la présente invention prévoit un décodeur en temps réel d'une donnée appartenant à un sous-groupe de P données faisant elles-mêmes partie d'un groupe de N données avec P inférieur ou égal à N, comprenant: un premier registre de N cases, chacune de ces cases correspondant de façon ordonnée à l'une des données, la présence ou l'absence de chaque donnée étant indiquée par l'état binaire de la case correspondante, P données parmi les N étant présentes; un deuxième registre de P cases dont l'une, correspondant au numéro parmi P de la donnée à décoder, est dans un état binaire différent de celui des autres; un circuit d'aiguillage à P lignes et N colonnes, chaque intersection de ligne et de colonne étant occupée par une cellule comprenant une borne de commande d'aiguillage, une entrée et deux sorties, la première sortie étant reliée à l'entrée de la cellule suivante de la même ligne, la deuxième sortie étant reliée à l'entrée de la cellule suivante de la ligne suivante de rang inférieur, sauf en ce qui concerne les cellules de la ligne de rang le plus faible pour lesquelles la deuxième sortie est reliée à une borne de sortie; les P entrées des cellules de la première colonne étant reliées aux cases du deuxième registre; les commandes d'aiguillage de toutes les cellules d'une colonne étant reliées à une case du premier registre pour relier l'entrée de chaque cellule vers la première ou la deuxième sortie de cette cellule selon le contenu de la case; d'où il résulte que l'on retrouve sur les bornes de sortie des cellules de la ligne de plus faible rang un état binaire différent pour la colonne parmi les N correspondant à la donnée parmi les P fixée dans le deuxième registre.

Des modes de réalisation particuliers des cellules du circuit d'aiguillage ainsi qu'une application de la présente invention à un système d'affichage de signes graphiques ou alphanumériques seront exposés dans la description détaillée ci-après. Cette description est faite en relation avec les figures jointes parmi lesquelles:

— la figure 1 représente divers registres et servira de soutien à un exposé général des buts de l'invention;

— la figure 2 représente sous forme de blocs un décodeur selon la présente invention;

— la figure 3 représente schématiquement sous forme de relais des cellules d'un décodeur selon la présente invention;

— la figure 4 représente schématiquement une réalisation sous forme de transistors MOS de cellules d'un décodeur selon la présente invention; et

— la figure 5 illustre une application d'un décodeur selon la présente invention à un circuit d'affichage graphique ou alphanumérique.

Dans ce qui suit, on prendra essentiellement comme exemple le cas ou le nombre $N = 8$ ($n = 3$) et où le nombre $P = 4$ ($p = 2$).

Etant donné un ensemble de huit (N) objets ou données ou mots, désignés par les lettres A à H, et rassemblés dans une mémoire ou registre de données 10, on cherche à désigner parmi ces huit données, quatre (P) d'entre elles, par exemple les données B, C, F et H. Pour ce faire, on associe au registre de données 10 un registre image 20 comprenant également N (huit) cases, dans lesquelles on introduit un état binaire distinct selon que la donnée correspondante appartient ou non au sous-groupe sélectionné. Ainsi, on a associé l'état binaire 0 aux données A, D, E, G et l'état binaire 1 aux données B, C, F et H. On cherche à identifier la lettre F en l'identifiant par son numéro d'ordre (i) dans le sous-groupe des P (quatre) données présentes, c'est-à-dire le numéro 3 dans le sous-groupe des données B, C, F et H. Le décodeur doit permettre de convertir cette indication (i) du numéro d'ordre dans le sous-groupe en une indication (j) du numéro d'ordre dans le groupe de N données figurant dans le registre image 20, ce deuxième numéro d'ordre étant, dans le cas illustré, le numéro 6 pour la lettre F.

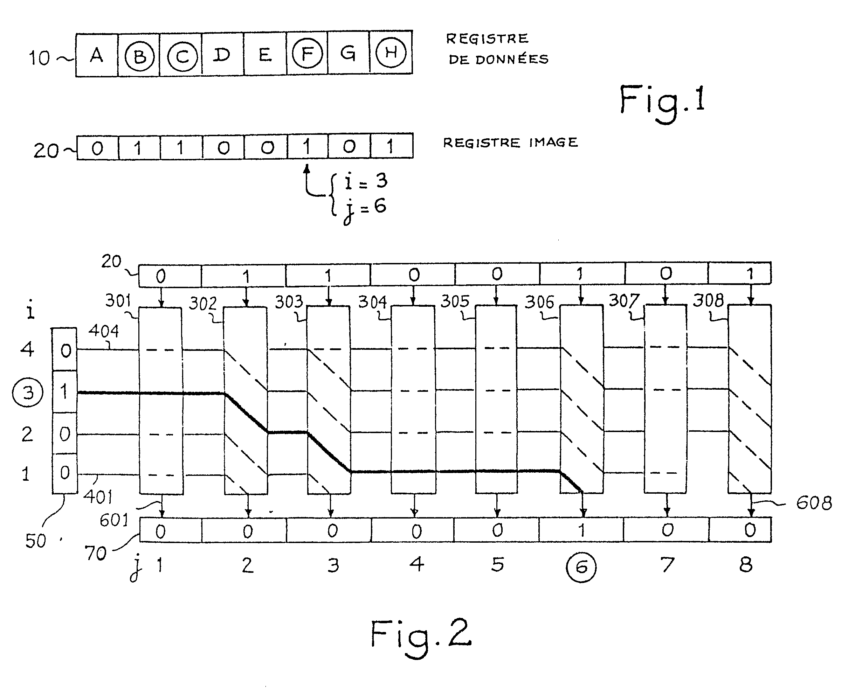

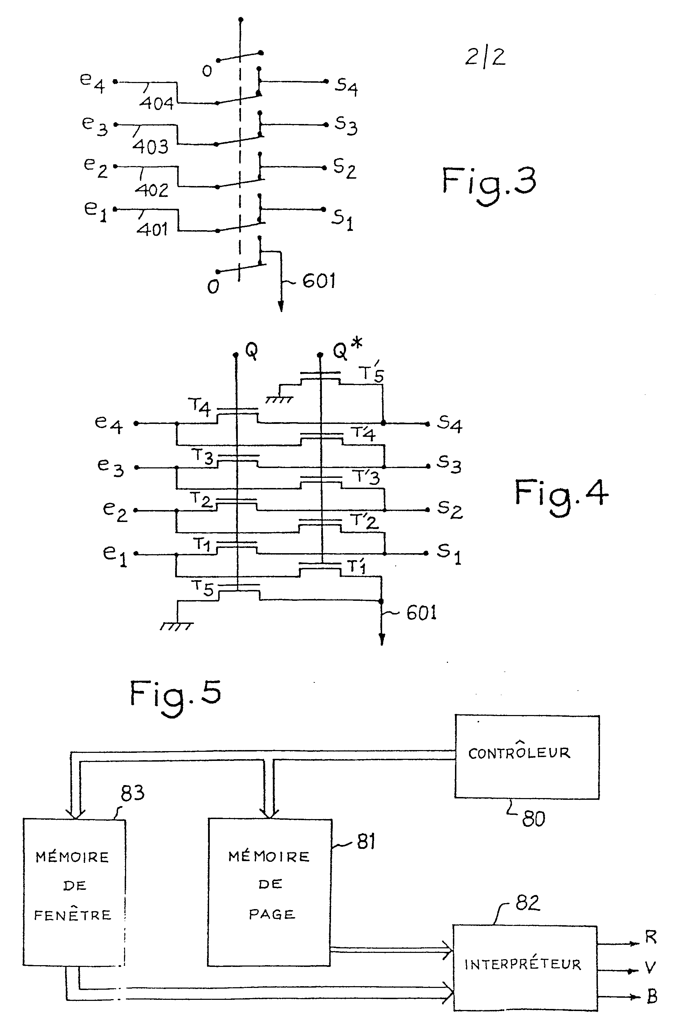

Le décodeur selon la présente invention comprend un ensemble de cellules d'aiguillage disposées selon P lignes et N colonnes. En figure 2, les P cellules d'une même colonne ne sont pas représentées individuellement; on a seulement représenté sous forme de blocs (301 à 308) les N (huit) ensembles de cellules constituant les colonnes du circuit d'aiguillage. Des réalisations de ces blocs seront décrites en relation avec les figures 3 et 4. Les P cellules de chacune des colonnes respectives (301 ... 308) sont commandées par une sortie respective du registre image 20 mentionné précédemment. L'entrée (401 à 404) de chaque ligne (c'est-à-dire les entrées des cellules de la première colonne) reçoit un signal dans un premier ou un second état binaire, figuré dans un registre 50, le second état binaire, par exemple un 1, correspondant à l'indication du numéro parmi P de la donnée que l'on cherche à identifier. En d'autres termes, la $i^{ème}$ case du registre 50 est à l'état 1, i étant le numéro parmi P de la donnée recherchée. Chaque cellule d'une colonne transmet le signal de son entrée vers l'entrée de la cellule de la colonne suivante et de la même ligne, si les cellules de cette colonne correspondent à un contenu 0 dans le registre 20. Si le contenu de la case du registre image 20 correspondant à une colonne de cellules est à 1, toutes les cellules de cette colonne auront pour effet de transmettre le signal à leur entrée vers l'entrée des cellules de la colonne suivante, mais de la ligne de rang inférieur. La cellule inférieure de chaque colonne est connectée à une borne de sortie (601 à 608). Le signal d'entrée de cette dernière cellule est dirigé vers la borne de sortie si la commande de cette cellule est à 1 et vers la cellule correspondante de la colonne suivante si le signal de commande de cette cellule est à 0.

Dans la figure 2, on a représenté le cas où l'on cherche à identifier le numéro j parmi N d'une donnée dont le numéro i parmi P est égal à trois. Ainsi, dans le registre 50, la troisième case contient un 1 et les autres cases contiennent un 0. La première cellule rencontrée est commandée par un 0 du registre 20 et transmet sa sortie à l'entrée de la cellule suivante de même rang de la colonne 302. Par contre, au niveau des colonnes 302 et 303, qui sont commandées par des 1 dans le registre 20, le signal d'entrée est transmis vers la cellule de la colonne suivante de niveau inférieur. Dans les cellules des colonnes 304 et 305, commandées par des 0, aucun décalage du signal de sortie par rapport au signal d'entrée n'apparaît. Puis, au niveau de la cellule inférieure de la colonne 306, qui est commandée par un 1, le signal d'entrée est envoyé vers la borne de sortie. On obtient donc aux sorties 601 à 608 une succession de 0, puis un 1 à l'emplacement correspondant à la donnée sélectionnée. La position de ce 1 correspond au numéro j parmi N de la donnée sélectionnée. Dans l'exemple représenté, il apparaît que la troisième parmi les P données est la sixième parmi les N données. Les bornes de sorties 601 à 608 ont été figurées comme connectées à un registre 70: normalement ce registre pourra être le même que le registre de données 10 de la figure 1.

Les cellules de la figure 2 peuvent être réalisées sous forme de relais comme cela est représenté en figure 3 pour les cellules d'une même colonne, par exemple de la première colonne 301. Cette colonne comprend quatre entrées e1 à e4 correspondant aux lignes 401 à 404, quatre sorties s1 à s4 vers les entrées des cellules de la colonne suivante et une sortie de commande 601. Dans le cas représenté où la colonne considérée est commandée par un 0, chacune des entrées e1 à e4 est connectée à la sortie correspondante s1 à s4 et la sortie de commande 601 est connectée à une source de tension correspondant à l'état binaire 0, par exemple la masse. Si par contre cette colonne de cellules est commandée par un 1, tous les relais représentés passent en position basse, la sortie s4 est reliée à une tension de référence correspondant à l'état 0, par exemple la masse, la sortie s3 est reliée à l'entrée e4, la sortie s2 à l'entrée e3, la sortie s1 à l'entrée e2 et la sortie de commande 601 à l'entrée e1.

La figure 4 représente un mode de réalisation d'une colonne de cellules selon la présente invention utilisant des transistors MOS T1 à T4 et T'1 à T'4. Les transistors MOS T1 à T4 d'une part et les transistors MOS T'1 à T'4 d'autre part sont commandés par des signaux complémentaires Q et Q*, le signal Q par exemple correspondant au contenu du registre 20 de la figure 2. Ainsi, si les transistors MOS T1 à T4 sont conducteurs, les entrées et les sorties de même rang sont reliées. Par contre, si les transistors MOS T'1 à T'4 sont conducteurs, les entrées sont reliées aux sorties de rang inférieur, l'entrée e1 étant connectée à la borne de commande 601. En outre, deux transistors T5 et T'5 sont destinés à éviter que dans certains cas des bornes se trouvant «en l'air». Dans cette réalisation, le circuit d'aiguillage selon la présente invention comprendra donc seulement (2P + 2)N transistors MOS.

Encore convient-il de remarquer que certaines des cellules apparaissant dans le circuit d'aiguillage de la figure 2 peuvent être supprimées, notamment, les trois dernières cellules (ou cellules supérieures) de la dernière colonne 308, les deux dernières cellules de l'avant-dernière colonne 307 et la dernière cellule de l'anté-pénultième colonne 306. De façon générale, on peut supprimer P − 1 cellules de la dernière colonne, P − 2 cellules de la colonne précédente, P − 3 cellules de la colonne précédente, et ainsi de suite. En effet, puisqu'il y a en tout P descentes de niveaux, dès la $(N − P + 1)^{ième}$ colonne, on est sûr qu'une descente de niveau a déjà eu lieu. La cellule supérieure de cette colonne est donc non nécessaire et ainsi de suite pour les colonnes suivantes. Néanmoins, dans certains cas, pour simplifier la réalisation automatique des masques correspondant à l'implantation du circuit intégré, on préférera maintenir les cellules inutiles.

La figure 5 illustre un cas où la présente invention peut s'appliquer de façon particulièrement intéressante, c'est le cas d'un afficheur graphique couleur. Dans un tel afficheur, un contrôleur 80 fournit des signaux indicatifs d'un balayage d'écran et d'adressage d'une mémoire de page. La mémoire de page 81 contient les informations correspondant à la couleur de chaque point de l'écran. C'est donc une mémoire de grande dimension, par exemple de 80 000 cases. Le contenu de chaque case, adressé séquentiellement, est envoyé à un interpréteur 82, qui fournit, pour le point adressé correspondant à l'instant présent du balayage, des informations sur la proportion, ou la présence ou l'absence, des informations R, V, B (rouge, vert, bleu) pour les trois canons de l'afficheur couleur. On peur obtenir huit couleurs sur l'écran si chacun des canons peut être excité à l'une ou l'autre de deux valeurs. Ainsi, pour mémoriser l'une ou l'autre de ces huit informations, la mémoire de page doit normalement contenir trois bits par case.

Pour réduire la dimension de cette mémoire, on souhaite par exemple ne prévoir que deux bits par case, ce qui réduit d'un tiers la dimension de la mémoire de page, mais qui limite bien entendu la possibilité de choix de couleur à quatre. Il a été proposé de diviser la page ou l'écran en fenêtres, par exemple de dimensions 6×10 pas élémentaires et dans chaque fenêtre de n'inclure que quatre couleurs. On peut alors, à condition de prévoir une mémoire de fenêtre 83 indiquant pour chaque instant du balayage quel est l'ensemble de quatre couleurs choisi, ne mémoriser dans la mémoire de page que deux informations par case. L'interpréteur 82 peut typiquement être un circuit selon la présente invention, la mémoire de fenêtre fournissant à tout instant le contenu du registre image 20 des figures 1 et 2 et la mémoire de page fournissant le contenu du registre 50 de la figure 2. Avec le circuit d'aiguillage simple selon la présente invention, l'économie d'un tiers de la capacité de la mémoire de page, c'est-à-dire de sensiblement 80 000 points mémoire, est particulièrement intéressante vu le faible nombre de composants additionnels nécessaires et vu que ces composants additionnels peuvent simplement être réalisés dans un circuit intégré par des techniques classiques.

Bien que l'on ait décrit la présente invention seulement dans le cas où P = 4 et où N = 8, bien entendu l'invention s'applique à des valeurs quelconques de P et N pour autant que P soit inférieure ou égal à N. D'autre part, bien qu'une application particulière de la présente invention a été décrite, l'invention pourra s'appliquer à de nombreux autres systèmes informatiques.

**Revendications**

1. Décodeur en temps réel d'une donnée comprise dans un sous-groupe de P données appartenant à un groupe de N données (P inférieur ou égal à N) comprenant:
   – un premier registre (20) de N cases, chacune de ces cases correspondant de façon ordonnée à une des données, la présence ou l'absence de chaque donnée étant indiquée par l'état binaire de la case correspondante, P données parmi les N étant présentes;
   – un deuxième registre (50) de P cases dont l'une, correspondant au numéro (i) parmi P de la donnée à décoder, est dans un état binaire distinct de celui des autres cases; caractérisé en ce qu'il comprend en outre un circuit d'aiguillage à P lignes (401 à 404) et N colonnes (301 à 308), chaque intersection de ligne et de colonne étant occupée par une cellule comprenant une borne de commande d'aiguillage, une entrée et deux sorties, la première sortie étant reliée à l'entrée de la cellule suivante de la même ligne, la deuxième sortie étant reliée à l'entrée de la cellule suivante de la ligne suivante de rang inférieur, sauf en ce qui concerne les cellules de la ligne du rang le plus faible pour lesquelles la deuxième sortie est reliée à une borne de sortie (601 à 608), les P entrées des cellules de la première colonne (301) étant reliées aux cases du deuxième registre; les commandes d'aiguillage de toutes les cellules d'une même colonne étant reliées à une case du premier registre pour relier l'entrée de chaque cellule vers la première ou la deuxième sortie de cette cellule selon le contenu de la case; d'où il résulte que l'on retrouve sur les bornes de sortie des cellules de la ligne de plus faible rang un état binaire différent dans la colonne j parmi les N qui correspond à la donnée parmi P fixée dans le deuxième registre.

2. Décodeur selon la revendication 1, caractérisé en ce que chaque cellule est constituée d'un relais à une entrée et deux sorties.

3. Décodeur selon la revendication 1, caractérisé en ce que chaque cellule comprend deux transistors MOS commandés par des signaux complémentaires, l'un de ces transistors étant connecté à l'entrée de la cellule suivante de même rang et l'autre de ces transistors étant connecté à l'entrée de la cellule suivante de rang inférieur.

**Patentansprüche**

1. Realzeit-Decoder für eine Datengrösse innerhalb einer Untergruppe von P Datengrössen, welche einer Gruppe von N Datengrössen angehören (P kleiner als oder gleich N), enthaltend:
   – ein erstes Register (20) mit N Feldern, wobei jedes dieser Felder in geordneter Weise einer der Datengrössen entspricht, die Anwesenheit oder Abwesenheit jeder Datengrösse durch den Binärzustand des entsprechenden Feldes angezeigt wird und P unter den N Datengrössen vorhanden sind;

– ein zweites Register (50) mit P Feldern, von denen eines, welches der Nummer (i) der unter den P zu decodierenden Datengrösse entspricht, sich in einem Binärzustand befindet, der verschieden von dem der anderen Felder ist; dadurch gekennzeichnet, dass er ferner eine Umlenkschaltung mit P Zeilen (401 bis 404) und N Spalten (301 bis 308) enthält, wobei jeder Schnittpunkt zwischen Zeile und Spalte von einer Zelle eingenommen wird, die einen Umlenksteuereingang, einen Eingang und zwei Ausgänge aufweist, wobei der erste Ausgang mit dem Eingang der darauffolgenden Zelle derselben Zeile, der zweite Ausgang mit dem Eingang der darauffolgenden Zelle der darauffolgenden Zeile niedrigerer Ordnungszahl verbunden ist, mit Ausnahme der Zellen der Zeile niedrigster Ordnungszahl, bei welcher der zweite Ausgang mit einem Ausgangsanschluss (601 bis 608) verbunden ist, wobei ferner die P Eingänge der Zellen der ersten Spalte (301) mit den Feldern des zweiten Registers verbunden sind; wobei die Umlenksteuerungen aller Zellen derselben Spalte mit einem Feld des ersten Registers verbunden sind, um den Eingang jeder Zelle mit dem ersten oder dem zweiten Ausgang dieser Zelle je nach dem Inhalt des Feldes zu verbinden; woraus sich ergibt, dass an den Ausgangsanschlüssen der Zellen der Zeile niedrigster Ordnungszahl ein Binärzustand angetroffen wird, der in derjenigen Spalte j unter N, welche der in dem zweiten Register festgelegten Datengrösse unter den P entspricht, unterschiedlich ist.

2. Decoder nach Anspruch 1, dadurch gekennzeichnet, dass jede Zelle durch ein Relais mit einem Eingang und zwei Ausgängen gebildet ist.

3. Decoder nach Anspruch 1, dadurch gekennzeichnet, dass jede Zelle zwei MOS-Transistoren enthält, welche durch komplementäre Signale gesteuert werden, wobei einer dieser Transistoren mit dem Eingang der darauffolgenden Zelle gleicher Ordnungszahl und der andere Transistor mit dem Eingang der darauffolgenden Zelle niedrigerer Ordnungszahl verbunden ist.

## Claims

1. Real time decoder for a data comprised in a sub-group of P data belonging to a group of N data (P smaller than or equal to N), comprising:

– a first register (20) of N fields, each of these fields corresponding in orderly manner to one of these data, the presence or absence of each data being indicated by the binary state of the corresponding field, P data among the N being present;

– a second register (50) of P fields, one of which, corresponding to the number (i) among P of the data to be decoded, is in a binary state distinct from that of the other fields;

– characterized in that it further comprises a changeover circuit with P lines (401 to 404) and N columns (301 to 308), each line and column intersection being occupied by one cell comprising a change-over control terminal, one input and two outputs, the first output being connected to the input of the following cell of the same line, the second output being connected to the input of the following cell of the following line of inferior order, except for the cells of the line of the lowest order whereof the second output is connected to an output terminal (601–608), the P inputs of the cells of the first column (301) being connected to the fields of the second register; the change-over controls of all of the cells of the same column being connected to a field of the first register to connect the input of each cell to the first or the second output of this cell according to the content of the field; whereby a binary state different in the column j among the N which corresponds to the data among P fixed in the second register is encountered on the output terminals of the cells of the line of lowest order.

2. Decoder according to claim 1, characterized in that each cell is constituted of a relay having one input and two outputs.

3. Decoder according to claim 1, characterized in that each cell comprises two MOS transistors controlled by complementary signals, one of these transistors being connected to the input of the following cell of the same order and the other of these transistors being connected to the input of the following cell of inferior order.

REGISTRE
DE DONNÉES

$10 \sim$ | A | Ⓑ | Ⓒ | D | E | Ⓕ | G | Ⓗ |

# Fig.1

REGISTRE IMAGE

$20 \sim$ | 0 | 1 | 1 | 0 | 0 | 1 | 0 | 1 |

$\begin{cases} i = 3 \\ j = 6 \end{cases}$

Fig.2

2/2

Fig.3

Fig.4

Fig.5

CONTRÔLEUR
80

MÉMOIRE DE FENÊTRE 83

MÉMOIRE DE PAGE 81

INTERPRÉTEUR 82

R
V
B